# EUROPÄISCHE PATENTSCHRIFT

(11) **EP 2 954 613 B1**
(45) Veröffentlichungstag und Bekanntmachung des Hinweises auf die Patenterteilung: **05.06.2019**
(21) Anmeldenummer: 14702830.2
(22) Anmeldetag: 03.02.2014
(51) Int. Cl.: H03H 1/00, H02G 5/00

(54) **FILTERBAUELEMENT**
FILTER COMPONENT
ELÉMENT DE FILTRE

(30) Priorität: 11.02.2013 DE 102013101323
(43) Veröffentlichungstag der Anmeldung: 16.12.2015
(73) Patentinhaber: TDK Electronics AG, 81671 München (DE)
(72) Erfinder: BECK, Fabian, CH-4522 Rüttenen (CH)
(74) Vertreter: Epping - Hermann - Fischer
(86) Internationale Anmeldenummer: PCT/EP2014/052055
(87) Internationale Veröffentlichungsnummer: WO 2014/122095

(56) Entgegenhaltungen:
- DE-A1-102005 013 509
- US-A1- 2009 015 992
- "DC Filters FN2200 - DC EMC/EMI Filter for PV Inverters", , 1. Februar 2012 (2012-02-01), XP055118379, Gefunden im Internet: URL:http://www.hyteps.nl/documenten/freque ntieregelaars/Datasheet-FN2200.pdf [gefunden am 2014-05-16]
- Epcos Ag: "EMC filters 2-line filters SIFI-G for enhanced insertion loss Rated current 3 to 36 A", , 1. Januar 2006 (2006-01-01), XP055117793, Gefunden im Internet: URL:http://www.farnell.com/datasheets/3180 0.pdf [gefunden am 2014-05-13]

## Beschreibung

Die vorliegende Erfindung betrifft ein Filterbauelement, insbesondere ein EMV-Filter.

Ein EMV-Filter ist in DE 102005013509 A1 beschrieben. In den Mitteilungen von Schaffner: "DC Filters FN2200-DC EMC/EMI Filter for PV Inverters", 1. Februar 2012, XP055118379 und von EPCOS: "EMC filters 2-line filters SIFI-G enhanced insertion loss Rated current 3 to 36 A", 1. Januar 2006, XP055117793 sind weitere Filterbauelemente spezifiziert. In der Anmeldeschrift US 2009/015992 A1 ist eine Konverterschaltung beschrieben, bei der zwei elektrische Bauelemente über eine laminierte Leiterbahnstruktur miteinander verbunden sind.

Im Automotive-Bereich, beispielsweise bei Hybrid- und Elektro-Fahrzeugen, sind lange Verbindungen eines Hochvolt-Busses zwischen einer Hochvolt-Batterie und einer Antriebseinheit zu realisieren. Die Antriebseinheit kann typischerweise auf der Verbindungsleitung eine Störspannung von 120 dBµV bei 150 kHz erzeugen. Zukünftig ist geplant, dass der Hochvolt-Bus eine offene Architektur aufweist, so dass eine Vielzahl von Komponenten im Fahrzeug, beispielsweise Wechselspannungsgeneratoren, Pumpen, etc., auf den gemeinsamen Hochvolt-Bus zugreifen können. Daher ist es erforderlich, die Verbindungen zwischen der Hochvolt-Batterie und der Antriebseinheit durch aufwändig geschirmte Stecker und Leitungen zu realisieren.

Es ist ein Anliegen, ein Filterbauelement bereitzustellen, das es ermöglicht, Störspannungen auf einer elektrischen Leitung ausreichend zu unterdrücken, einen geringen Platzbedarf aufweist und möglichst einfach zu montieren ist.

Ein solches Filterbauelement ist im Patentanspruch 1 angegeben.

Gemäß der im Anspruch 1 angegebenen Ausführungsform umfasst das Filterbauelement einen Gehäusekörper und mindestens zwei Stromschienen, die jeweils einen ersten Endabschnitt und einen zweiten Endabschnitt, zwischen denen jeweils ein mittlerer Abschnitt angeordnet ist, aufweisen. Das Filterbauelement weist darüber hinaus mindestens einen magnetischen Kern, der in dem Gehäusekörper angeordnet ist und den jeweiligen mittleren Abschnitt der mindestens zwei Stromschienen umgibt, auf. Darüber hinaus umfasst das Filterbauelement mindestens einen ersten Kondensator, einen zweiten Kondensator und einen dritten Kondensator.

Eine erste der Stromschienen weist einen ersten Anschluss zum Anschließen eines ersten Potentials und einen zweiten Anschluss zum Anschließen einer ersten Last auf. Mindestens eine zweite der Stromschienen weist einen ersten Anschluss zum Anschließen eines zweiten von dem ersten Potential verschiedenen Potentials und einen zweiten Anschluss zum Anschließen einer zweiten von der ersten Last verschiedenen Last oder zum Anschließen eines Bezugspotentials auf. Der jeweilige erste Anschluss ist in dem jeweiligen ersten Endabschnitt und der jeweilige zweite Anschluss ist in dem jeweiligen zweiten Endabschnitt der mindestens zwei Stromschienen angeordnet. Der jeweilige erste Endabschnitt der mindestens zwei Stromschienen tritt an einer ersten Seite des Gehäusekörpers aus dem Gehäusekörper aus. Der jeweilige zweite Endabschnitt der mindestens zwei Stromschienen tritt an einer zweiten von der ersten Seite verschiedenen Seite des Gehäusekörpers aus dem Gehäusekörper aus. Der jeweilige mittlere Abschnitt der mindestens zwei Stromschienen ist in dem Gehäusekörper angeordnet. Der erste Endabschnitt, der zweite Endabschnitt und der mittlere Abschnitt der ersten Stromschiene sind in einer ersten Ebene angeordnet. Der erste Endabschnitt, der zweite Endabschnitt und der mittlere Abschnitt der mindestens einen zweiten Stromschiene sind in einer von der ersten Ebene verschiedenen zweiten Ebene angeordnet.

Der jeweilige erste Endabschnitt der mindestens zwei Stromschienen ist derart geformt, dass der erste Anschluss der ersten Stromschiene und der erste Anschluss der mindestens einen zweiten Stromschiene nicht zueinander fluchtend ausgerichtet sind. Der jeweilige zweite Endabschnitt der mindestens zwei Stromschienen ist derart geformt, dass der zweite Anschluss der ersten Stromschiene und der zweite Anschluss der mindestens einen zweiten Stromschiene nicht zueinander fluchtend ausgerichtet sind.

Die mindestens zwei Stromschienen sind über einen jeweiligen des mindestens einen ersten und zweiten Kondensators mit dem Bezugspotential verbunden. Der mindestens eine dritte Kondensator verbindet die mindestens zwei Stromschienen miteinander.

Das Filterbauelement kann als ein EMV-Filter eingesetzt werden. Da die Endabschnitte mit den Anschlüssen für jede Stromschiene in der gleichen Ebene liegen und die beiden Stromschienen in verschiedenen Ebenen angeordnet sind, kann die Montage der Anschlüsse des Filterbauelements an weiterführende Leiter von einer Montagerichtung aus erfolgen. Wenn die Endabschnitte der ersten und der mindestens einen zweiten Stromschiene in der jeweiligen Ebene in unterschiedliche Richtungen angeordnet sind, sind sämtliche Anschlüsse aus einer Montagerichtung leicht zugänglich, um beispielsweise eine Verschraubung an die weiterführenden Leiter durchzuführen. Die erste und die mindestens eine zweite Stromschiene kann dazu L-förmig gebogen sein. Die L-förmige Geometrie der Stromschienen hat den weiteren Vorteil, dass beispielsweise beim Ausstanzen der Stromschienen aus einem Blech nur eine geringer Materialverbrauch anfällt.

Weitere vorteilhafte Ausführungsformen des Filterbauelements sind den Unteransprüchen zu entnehmen.

Die Erfindung wird im Folgenden anhand von Figuren, die Ausführungsform der vorliegenden Erfindung zeigen, näher erläutert. Es zeigen:
- Figur 1: eine Ausführungsform eines Filterbauelements zum Filtern einer Störspannung auf einer elektrischen Leitung,
- Figur 2: eine Ausführungsform von mindestens zwei Stromschienen für ein Filterbauelement zum Filtern einer Störspannung auf einer elektrischen Leitung,
- Figur 3: eine Anordnung einer Ausführungsform von mindestens zwei Stromschienen für ein Filterbauelement zum Filtern einer Störspannung auf einer elektrischen Leitung,
- Figur 4A: eine Draufsicht auf eine Anordnung von mindestens zwei Stromschienen für ein Filterbauelemente zum Filtern einer Störspannung auf einer elektrischen Leitung,
- Figur 4B: eine Queransicht auf eine Anordnung von mindestens zwei Stromschienen für ein Filterbauelement zum Filtern einer Störspannung auf einer elektrischen Leitung,
- Figur 5: eine weitere Ausführungsform von mindestens zwei Stromschienen für ein Filterbauelement zum Filtern einer Störspannung auf einer elektrischen Leitung,
- Figur 6: eine Ausführungsform eines Filterbauelement zum Filtern einer Störspannung auf einer elektrischen Leitung.

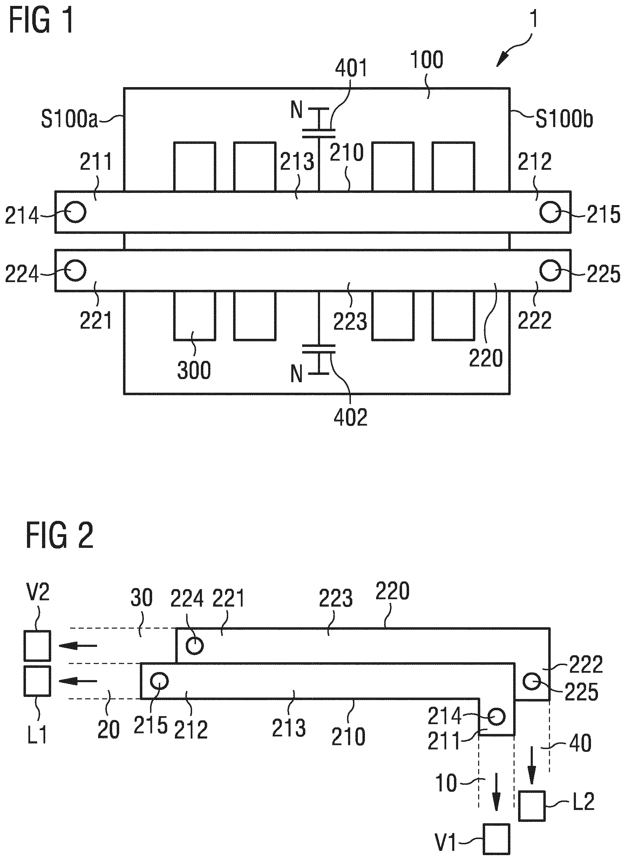

Figur 1 zeigt eine Draufsicht auf eine Ausführungsform eines Filterbauelements 1, insbesondere eines EMV-Filterbauele ments, zur Filterung eines Störsignals, das zusammen mit einem Nutzsignal auf einer elektrischen Leitung übertragen werden kann. Das Filterbauelement weist einen Gehäusekörper 100, in dem eine Stromschiene 210 und eine Stromschiene 220 angeordnet sind, auf. Die Stromschienen 210 und 220 können jeweils als Flachleiter ausgebildet sein. Die Stromschiene 210 weist einen Endabschnitt 211, der auf einer Seite S100a des Gehäusekörpers aus dem Gehäuse austritt, auf. Ein weiterer Endabschnitt 212 der Stromschiene 210 ragt auf einer gegenüberliegenden Seite S100b aus dem Gehäusekörper heraus. Ein mittlerer Abschnitt 213 der Stromschiene 210 ist im Inneren des Gehäuses angeordnet. Die Stromschiene 220 weist einen Endabschnitt 221, der aus der Seite S100a des Gehäuses 100 austritt, auf. Ein weiterer Endabschnitt 222 der Stromschiene 220 tritt auf einer Seite S100b aus dem Gehäusekörper 100 aus. Ein mittlerer Abschnitt 223 der Stromschiene 220 verläuft im Inneren des Gehäuses.

Zum Anschließen des Filterbauelements 1 an elektrische Leiter weist die Stromschiene 210 einen Anschluss 214 und einen Anschluss 215 auf. Der Anschluss 214 ist an dem Endabschnitt 211 der Stromschiene 210 angeordnet. Der Anschluss 215 ist an dem Endabschnitt 212 der Stromschiene 210 angeordnet. Mit dem Anschluss 214 kann die Stromschiene 210 beispielsweise an eine Versorgungsspannung, zum Beispiel an eine Batterie, angeschlossen sein. Der Anschluss 215 kann mit einer Last beziehungsweise einem Verbraucher verbunden werden. Die Stromschiene 220 weist zum Verbinden mit elektrischen Leitern ein Anschluss 224, der an dem Endabschnitt 221 der Stromschiene 220 angeordnet ist, und einen Anschluss 225, der an dem Endabschnitt 222 der Stromschiene 220 angeordnet ist, auf.

Die mittleren Abschnitte 213 und 223 der Stromschienen 210 und 220 sind im Inneren des Gehäusekörpers 100 von magnetischen Kernen 300 umgeben. Im Ausführungsbeispiel der Figur 1 sind im Inneren des Gehäusekörpers 100 beispielsweise vier magnetische Ringkerne, die die jeweiligen mittleren Abschnitte 213, 223 der Stromschienen 210 und 220 umgeben, angeordnet. Die Stromschiene 210 kann über einen Kondensator 401 mit einem Bezugsspannungsanschluss N, beispielsweise einem Masseanschluss, verbunden sein. Die Stromschiene 220 kann über einen Kondensator 402 mit dem Bezugsspannungsanschluss N verbunden sein.

Bei der in Figur 1 gezeigten Ausführungsform eines Filterbauelements sind die Stromschienen 210 und 220 als geradlinig verlaufende Flachleiter ausgebildet. Figur 2 zeigt eine Ausführungsform von Stromschienen 210, 220, die ebenfalls als Flachleiter ausgebildet sind, die jedoch im Unterschied zu der in Figur 1 gezeigten Ausführungsform der Stromschienen nicht geradlinig sondern L-förmig ausgebildet sind. Die Stromschienen 210 und 220 können in Abhängigkeit von ihrer Stromtragfähigkeit beispielsweise eine Länge zwischen 10 cm und 1 m, eine Breite zwischen 10 mm und 10 cm und eine Höhe/Dicke zwischen 1 mm und 20 mm aufweisen.

Die Stromschiene 210 weist einen Endabschnitt 211 mit einem Anschluss 214 zum Anschließen eines elektrischen Leiters 10 auf. Der Anschluss 214 kann über den elektrischen Leiter 10 mit einem Spannungspotential V1, beispielsweise dem Potential einer Versorgungsspannung, verbunden sein. Des Weiteren weist die Stromschiene 210 ein Endabschnitt 212 mit einem Anschluss 215 zum Anschließen einer elektrischen Last L1 auf. Der Anschluss 215 kann über einen elektrischen Leiter 20 mit der elektrischen Last L1 verbunden sein. Zwischen den beiden Endabschnitten 211 und 212 ist ein mittlerer Abschnitt 213 der Stromschiene 210 angeordnet.

Der Endabschnitt 211 ist kürzer als der übrige Teil der Stromschiene 210 aus dem mittlere Abschnitt 213 und dem Endabschnitt 212 ausgebildet. Der Endabschnitt 211, der Endabschnitt 212 und der mittlere Abschnitt 213 der Stromschiene 210 sind in einer gemeinsamen Ebene angeordnet. Anstelle der gradlinigen Ausbildung ist der Endabschnitt 211 zu den mittleren Abschnitt 213 in einem Winkel zwischen 80° und 100° angeordnet. Bei der in Figur 2 gezeigten Ausführungsform ist der Endabschnitt 211 zu den mittleren Abschnitt 213 rechtwinklig beziehungsweise in einem Winkel von 90° angeordnet.

Die Stromschiene 220 ist ähnlich wie die Stromschiene 210 aufgebaut. Sie umfasst einem Endabschnitt 221 mit einem Anschluss 224 zum Anschließen eines Spannungspotentials, beispielsweise zum Anschließen einer Versorgungsspannung V2, und einen Endabschnitt 222 mit einem Anschluss 225 zum Anschließen einer Last L2. An den Anschluss 224 kann beispielsweise ein elektrischer Leiter 30 angeschlossen sein, der den Anschluss 224 mit dem Spannungspotential V2 verbindet. An den Anschluss 225 kann ein elektrischer Leiter 40 angeschlossen sein, der den Anschluss 225 mit der Last L2 verbindet. Zwischen den Endabschnitten 221 und 222 ist ein mittlerer Abschnitt 223 der Stromschiene 220 angeordnet.

Bei der Stromschiene 220 ist der Endabschnitt 222 kürzer als der übrige Teil der Stromschiene 220 aus dem mittleren Abschnitt 223 und dem Endabschnitt 221 ausgebildet. Der Endabschnitt 221, der mittlere Abschnitt 223 und der Endabschnitt 222 sind in einer gemeinsamen Ebene angeordnet. Anstelle der gradlinigen Ausbildung ist der Endabschnitt 222 zu dem mittleren Abschnitt 223 in einem Winkel zwischen 80° und 100° angeordnet. Bei der in Figur 2 gezeigten Ausführungsform ist der Endabschnitt 222 zu den mittleren Abschnitt 223 rechtwinklig beziehungsweise in einem Winkel von 90° angeordnet.

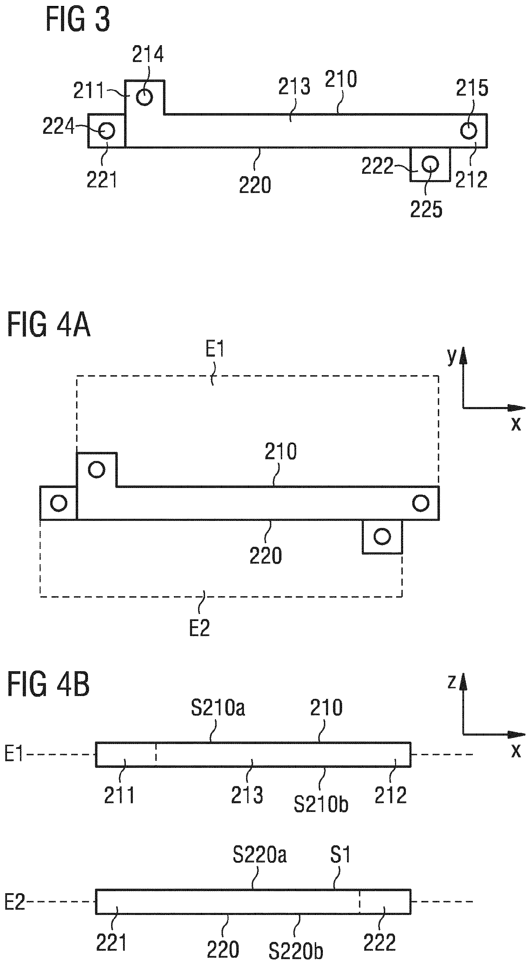

Figur 3 zeigt eine Anordnung der in Figur 2 gezeigten L-förmig ausgebildeten Stromschienen 210 und 220. Die beiden Stromschienen 210 und 220 sind in einer Stapelanordnung übereinander gestapelt. Die beiden Stromschienen sind derart in der Stapelanordnung angeordnet, dass der Endabschnitt 211 der Stromschiene 210 und der Endabschnitt 221 der Stromschiene 220 an einem Ende der Stapelanordnung angeordnet sind. Entsprechend sind in der Stapelanordnung der Endabschnitt 212 der Stromschiene 210 und der Endabschnitt 222 der Stromschiene 220 an dem anderen Ende der Anordnung angeordnet. Aufgrund der Formung der Endabschnitte 211 und 221 sind der Anschluss 214 der Stromschiene 210 und der Anschluss 224 der Stromschiene 220 nicht zueinander fluchtend ausgerichtet. Ebenso sind aufgrund der Formung der Endabschnitt 212 und 222 die Anschlüsse 215 und 225 nicht aufeinander fluchtend ausgerichtet.

Figur 4A zeigt, dass bei der in Figur 3 gezeigten Anordnung der Stromschiene 210 die Endabschnitte 211, 212 und der mittlere Abschnitt 213 der Stromschiene 210 in einer gemeinsamen Ebene E1 angeordnet sind. Die Ebene E1 wird in einer x- und y-Richtung aufgespannt. Bei der Stromschiene 210 ist der Endabschnitt 211 innerhalb der Ebene E1 in einer anderen Richtung als der mittlere Abschnitt 213 ausgerichtet. Der Endabschnitt 212 der Stromschiene 210 ist innerhalb der Ebene E1 in die gleiche Richtung wie der mittlere Abschnitt 213 ausgerichtet.

Bei der Stromschiene 220 sind die Endabschnitte 221, 222 und der mittlere Abschnitt 223 in einer gemeinsamen Ebene E2 angeordnet. Die Ebene E2 wird wie die Ebene E1 in einer x- und y-Richtung aufgespannt. Die Ebene E1, in der die Stromschiene 210 angeordnet ist, und die Ebene E2, in der die Stromschiene 220 angeordnet ist, sind zueinander versetzt angeordnet. Bei der Stromschiene 220 ist der Endabschnitt 222 innerhalb der Ebene E2 in eine andere Richtung als der mittlere Abschnitt 223 ausgerichtet. Der Endabschnitt 221 der Stromschiene 210 ist innerhalb der Ebene E2 in die gleiche Richtung wie der mittlere Abschnitt 223 ausgerichtet. Dadurch sind die in den Endabschnitten 211 und 221 vorhandenen Anschlüsse 214 und 224 beziehungsweise die in den Endabschnitten 212 und 222 enthaltenen Anschlüsse 215 und 225 nicht zueinander fluchtend ausgerichtet.

Figur 4B zeigt die als Flachleiter ausgebildete Stromschiene 210 und die als Flachleiter ausgebildete Stromschiene 220 in einer Queransicht. Die Stromschiene 210 weist eine Seitenfläche S210a und eine Seitenfläche S210b auf, wobei diese beiden Seitenflächen aufgrund der Geometrie des Flachleiters den größten Flächeninhalt sämtlicher Seitenflächen des Flachleiters aufweisen. Ebenso weist die als Flachleiter ausgebildete Stromschiene 220 eine Seitenfläche S220a und eine Seitenfläche S220b auf. Die beiden Seitenflächen S220a und S220b weisen von sämtlichen Seitenflächen des Flachleiters 220 den größten Flächeninhalt auf. Die Ebene E1 ist zwischen den Seitenflächen S210a und S210b parallel zu den Seitenflächen S210a und S210b angeordnet. Die Ebene E2 ist zwischen den Seitenflächen S220a und S220b parallel zu den Seitenflächen S220a und S220b angeordnet. Anhand von Figur 4B wird deutlich, dass die Ebenen E1 und E2, in der die beiden Stromschienen 210 und 220 angeordnet sind, zueinander versetzt angeordnet sind.

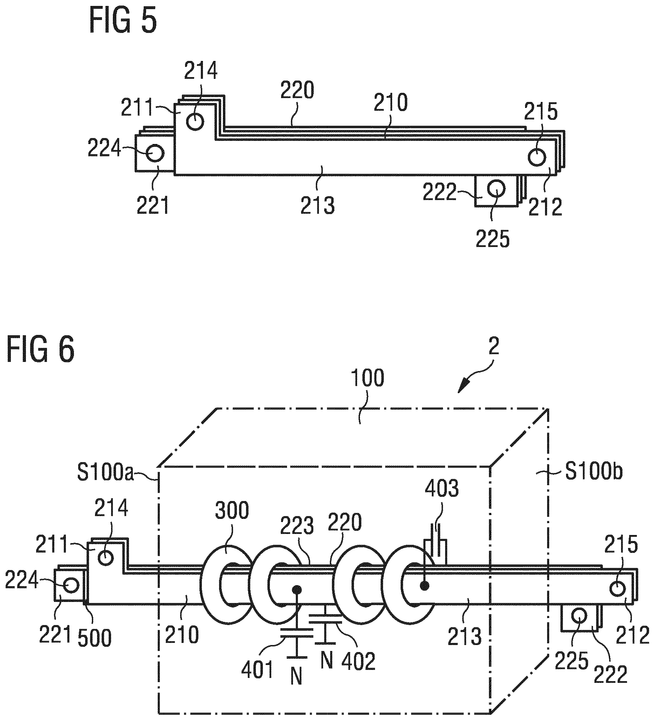

Figur 5 zeigt eine Ausführungsform von Stromschienen 210 und 220 eines Filterbauelements, wobei jede der Stromschienen mehrere elektrische Leiter umfasst. Die elektrischen Leiter können als Flachleiter ausgebildet sein. Die Stromschiene 210 weist beispielsweise die einzelnen elektrischen Leiter 210a und 210b auf, die übereinander gestapelt angeordnet sind. Die Stromschiene 220 weist die elektrischen Leiter 220a und 220b auf, die ebenfalls in einer Stapelanordnung übereinander angeordnet sind.

Die Leiter 210a und 210b weisen jeweils Endabschnitte 211 und 212 mit Anschlüssen 214 und 215 auf. Zwischen den jeweiligen Endabschnitten 211 und 212 ist ein mittlerer Abschnitt 213 der Leiter 210a, 210b angeordnet. Die elektrischen Leiter 220a und 220b weisen jeweils Endabschnitte 221 und 222 mit Anschlüssen 224 und 225 auf. Zwischen den jeweiligen Endabschnitten 221 und 222 ist ein mittlerer Abschnitt 223 der Leiter 220a, 220b angeordnet.

Bei der Stromschiene 210 sind die elektrischen Leiter 210a und 210b derart übereinander gestapelt angeordnet, dass die jeweiligen Endabschnitte 211 der elektrischen Leiter 210a, 210b übereinander angeordnet sind. Ebenso sind die jeweiligen Endabschnitt 212 der Leiter 210a, 210b und die jeweiligen mittleren Abschnitte 213 der Leiter 210a, 210b übereinander angeordnet. Die einzelnen Abschnitte können dabei, wie in Figur 5 gezeigt, deckungsgleich übereinander angeordnet sein. Somit sind auch die jeweiligen Anschlüsse 214 und 215 der elektrischen Leiter 210a, 210b deckungsgleich übereinander angeordnet.

Bei der Stromschiene 220 sind die elektrischen Leiter 220a und 220b derart übereinander gestapelt angeordnet, dass die jeweiligen Endabschnitte 221 der Leiter 220a, 220b übereinander angeordnet sind. Ebenso sind die jeweiligen Endabschnitte 222 der Leiter 220a, 220b und die jeweiligen mittleren Abschnitte 213 der Leiter 220a, 220b übereinander angeordnet. Die einzelnen Abschnitte können auch bei der Stromschiene 220, wie in Figur 5 gezeigt, deckungsgleich übereinander angeordnet sein. In diesem Fall sind auch die jeweiligen Anschlüsse 224 und 225 der elektrischen Leiter 220a, 220b deckungsgleich übereinander angeordnet.

Figur 6 zeigt eine Ausführungsform eines Filterbauelements 2, das als ein EMV-Filterbauelement zur Filterung eines Störsignals, das zusammen mit einem Nutzsignal auf einer elektrischen Leitung übertragen werden kann, ausgebildet ist. Das Filterbauelement 2 weist einen Gehäusekörper 100, in dem eine Stromschiene 210 und eine Stromschiene 220 angeordnet sind, auf. Die Stromschienen 210 und 220 können die in den Figuren 2, 3, 4A, 4B und 5 dargestellten Ausführungsformen aufweisen.

Die Stromschienen 210 und 220 können jeweils als Flachleiter ausgebildet sein. Bei der in Figur 6 gezeigten Ausführungsform des Filterbauelements weisen die Stromschienen 210 und 220, wie in Figur 5 gezeigt, mehrere gestapelte elektrische Leiter auf. Jede der Stromschienen kann auch, wie in Figur 3 gezeigt, jeweils nur einen elektrischen Leiter aufweisen. Die Stromschienen sind derart an dem Gehäusekörper angeordnet, dass der Endabschnitt 211, auf einer Seite S100a des Gehäusekörpers aus dem Gehäuse herausragt. Der Endabschnitt 212 ragt auf einer gegenüberliegenden Seite S100b aus dem Gehäusekörper 100 heraus. Ein mittlerer Abschnitt 213 der Stromschiene 210 ist im Inneren des Gehäuses angeordnet. Bei der Stromschiene 220 ragt der Endabschnitt 221 auf der Seite S100a des Gehäuses 100 aus dem Gehäusekörper heraus. Der Endabschnitt 222 der Stromschiene 220 tritt auf der Seite S100b aus dem Gehäusekörper 100 aus. Ein mittlerer Abschnitt 223 der Stromschiene 220 verläuft im Inneren des Gehäuses. Zur Isolationen der Stromschienen voneinander kann zwischen den Stromschienen 210 und 220 ein Isolator 500 angeordnet sein.

Zum Anschließen des Filterbauelements 1 an elektrische Leiter weist die Stromschiene 210 den Anschluss 214 und den Anschluss 215 auf. Der Anschluss 214 ist an dem Endabschnitt 211 der Stromschiene 210 angeordnet. Der Anschluss 215 ist an dem Endabschnitt 212 der Stromschiene 210 angeordnet. Mit dem Anschluss 214 kann die Stromschiene 210 beispielsweise an eine Versorgungsspannung, zum Beispiel an eine Batterie, angeschlossen sein. Der Anschluss 215 kann mit einer Last beziehungsweise einem Verbraucher verbunden werden. Die Stromschiene 220 weist zum Verbinden mit elektrischen Leitern den Anschluss 224, der an dem Endabschnitt 221 der Stromschiene 220 angeordnet ist, und den Anschluss 225, der an dem Endabschnitt 222 der Stromschiene 220 angeordnet ist, auf.

Die mittleren Abschnitte 213 und 223 der Stromschienen 210 und 220 sind im Inneren des Gehäusekörpers 100 von mindestens einem magnetischen Kern 300 umgeben. Im Ausführungsbeispiel der Figur 6 sind im Inneren des Gehäusekörpers 100 beispielsweise vier magnetische Ringkerne, die die jeweiligen mittleren Abschnitte 213, 223 der Stromschienen 210 und 220 umgeben, angeordnet. Das Filterbauelement kann mindestens zwei Kondensatoren aufweisen.

Die Stromschienen 210 und 220 sind jeweils über einen dieser Kondensatoren mit einem Bezugsspannungsanschluss N, beispielsweise einem Masseanschluss, verbunden. Die Stromschiene 210 kann über einen Kondensator 401 mit dem Bezugsspannungsanschluss N verbunden sein. Die Stromschiene 220 kann über einen Kondensator 402 mit dem Bezugsspannungsanschluss N verbunden sein. Alternativ oder zusätzlich dazu können die beiden Stromschienen über mindestens einen Kondensator untereinander verbunden sein. Bei dieser symmetrischen Ausführungsform des Filterbauelements kann ein Kondensator 403 zwischen die Stromschiene 210 und die Stromschiene 220 geschaltet sein.

Der Endabschnitt 211, der Endabschnitt 212 und der mittlere Abschnitt 213 der Stromschiene 210 sind in einer Ebene E1 angeordnet. Der Endabschnitt 221, der Endabschnitt 222 und der mittlere Abschnitt 223 der Stromschiene 220 sind in einer von der Ebene E1 verschiedenen Ebene E2 angeordnet. Im Unterschied zu der in Figur 1 gezeigten Ausführungsform 1 eines Filterbauelements sind die Stromschienen 210 und 220 somit nicht in einer gemeinsamen Ebene angeordnet. Stattdessen sind die Stromschienen 210 und 220, wie anhand der Figuren 3, 4A und 4B erläutert, in unterschiedlichen Ebenen E1 und E2 angeordnet. Dadurch kann der mindestens eine magnetische Kern 300 kleiner als bei der in Figur 1 gezeigten Variante eines Filterbauelements ausgebildet sein und ist daher deutlich wirkungsvoller als bei der in Figur 1 gezeigten Ausführungsform.

Die Anschlüsse 214, 215, 224 und 225 können jeweils als eine Fixierungseinrichtung zum Fixieren der elektrischen Leiter 10, 20, 30 und 40 ausgebildet sein. Sie können beispielsweise jeweils als eine Vertiefung oder als ein Schraubengewinde, an die die weiterführenden elektrischen Leiter angeschraubt werden können, in den jeweiligen Endabschnitten der Stromschienen 210 und 220 ausgebildet sein.

Da die Anschlüsse 214, 215 in den Endabschnitten 211, 212 der Stromschiene 210 enthalten sind, sind beide Anschlüsse in der gleichen Ebene E1 vorhanden. Ebenso sind auch die in den Endabschnitten 221 und 222 enthaltenen Anschlüsse 224, 225 der Stromschiene 220 in der gemeinsamen Ebene E2 angeordnet. Da, wie anhand der Figuren 3, 4A und 4B erläutert, die beiden Ebenen E1 und E2 parallel zueinander verlaufen, sind auch die Anschlüsse 214, 215, 224 und 225 in einer Richtung ausgerichtet. Dadurch wird es ermöglicht, die an die Anschlüsse 214, 215, 224 und 225 anzuschließenden elektrischen Leiter in Bezug auf den Gehäusekörper beziehungsweise in Bezug auf einen Untergrund, auf den der Gehäusekörper fixiert wird, aus einer Richtung mit den Stromschienen 210 und 220 zu verbinden. Da die an einer gemeinsamen Seite des Gehäusekörpers angeordneten Endabschnitte der Stromschienen 210 und 220 in ihrer jeweiligen Ebene in unterschiedlichen Richtungen angeordnet sind, überdecken sich die Anschlüsse nicht und sind somit aus einer Montagerichtung leicht zugänglich. Bei der Ausgestaltung der elektrischen Anschlüsse als Schraubengewinde kann die Verschraubung des Filterbauelements 2 mit den weiterführenden elektrischen Leitern kann somit aus einer Montagerichtung erfolgen.

Aufgrund der L-förmigen Geometrie der Stromschienen 210 und 220 kann die Montage der elektrischen Leiter an die Stromschienen aus einer Montagerichtung realisiert werden, ohne dass es erforderlich ist, die verschiedenen Abschnitte der Stromschienen untereinander zu verdrehen, auseinander zu biegen oder zu plätten. Des Weiteren tritt bei der Herstellung der Stromschienen, insbesondere bei einem Ausstanzen der Stromschienen aus einer Metallplatte, aufgrund der L-förmigen Geometrie der Stromschienen nur ein geringer Materialverbrauch auf. Die Montage des Filterbauelements ist aufgrund der L-förmigen Geometrie der Stromschienen erleichtert, da die Stromschienen von der Seite her in die Anordnung aus dem mindestens einen Ringkern eingeschoben werden können.

### Bezugszeichenliste

- 1, 2: Ausführungsformen eines Filterbauelements
- 100: Gehäusekörper
- 210: Stromschiene
- 211, 212: Endabschnitte der Stromschiene
- 213: mittlerer Abschnitt der Stromschiene
- 214, 215: Anschlüsse der Stromschiene
- 220: Stromschiene
- 221, 222: Endabschnitte der Stromschiene
- 223: mittlerer Abschnitt der Stromschiene
- 224, 225: Anschlüsse der Stromschiene
- 300: magnetischer Kern
- 401, 402, 403: Kondensator
- 500: Isolator

## Patentansprüche

1. Filterbauelement, umfassend:
- einen Gehäusekörper (100),
- mindestens zwei Stromschienen (210, 220), die jeweils einen ersten Endabschnitt (211, 221) und einen zweiten Endabschnitt (212, 222), zwischen denen jeweils ein mittlerer Abschnitt (213, 223) angeordnet ist, aufweisen,
- mindestens einen magnetischen Kern (300), wobei der mindestens eine magnetische Kern (300) in dem Gehäusekörper (100) angeordnet ist und den jeweiligen mittleren Abschnitt (213, 223) der mindestens zwei Stromschienen (210, 220) umgibt,
- mindestens einen ersten Kondensator (401), einen zweiten Kondensator (402) und einen dritten Kondensator (403),
- wobei eine erste der Stromschienen (210) einen ersten Anschluss (214) zum Anschließen eines ersten Potentials und einen zweiten Anschluss zum Anschließen einer ersten Last (L1) aufweist,
- wobei mindestens eine zweite der Stromschienen (220) einen ersten Anschluss (224) zum Anschließen eines zweiten von dem ersten Potential verschiedenen Potentials und einen zweiten Anschluss (225) zum Anschließen einer zweiten von der ersten Last verschiedenen Last (L2) oder zum Anschließen eines Bezugspotentials (N) aufweist,
- wobei der jeweilige erste Anschluss (214, 224) in dem jeweiligen ersten Endabschnitt (211) und der jeweilige zweite Anschluss (215, 225) in dem jeweiligen zweiten Endabschnitt (212, 222) der mindestens zwei Stromschienen angeordnet ist,
- wobei der jeweilige erste Endabschnitt (211, 221) der mindestens zwei Stromschienen (210, 220) an einer ersten Seite (S100a) des Gehäusekörpers (100) aus dem Gehäusekörper austritt und der jeweilige zweite Endabschnitt (212, 222) der mindestens zwei Stromschienen (210, 220) an einer zweiten von der ersten Seite verschiedenen Seite (S100b) des Gehäusekörpers (100) aus dem Gehäusekörper austritt und wobei der jeweilige mittlere Abschnitt (213, 223) der mindestens zwei Stromschienen in dem Gehäusekörper (100) angeordnet ist,
- wobei der erste Endabschnitt (211), der zweite Endabschnitt (212) und der mittlere Abschnitt (213) der ersten Stromschiene (210) in einer ersten Ebene (E1) angeordnet sind,
- wobei der erste Endabschnitt (221), der zweite Endabschnitt (222) und der mittlere Abschnitt (223) der mindestens einen zweiten Stromschiene (220) in einer von der ersten Ebene verschiedenen zweiten Ebene (E2) angeordnet sind,
- wobei der jeweilige erste Endabschnitt (211, 221) der mindestens zwei Stromschienen (210, 220) derart geformt ist, dass der erste Anschluss (214) der ersten Stromschiene (210) und der erste Anschluss (224) der mindestens einen zweiten Stromschiene (220) nicht zueinander fluchtend ausgerichtet sind,
- wobei der jeweilige zweite Endabschnitt (212, 222) der mindestens zwei Stromschienen (210, 220) derart geformt ist, dass der zweite Anschluss (215) der ersten Stromschiene (210) und der zweite Anschluss (225) der mindestens einen zweiten Stromschiene (220) nicht zueinander fluchtend ausgerichtet sind,
- wobei die mindestens zwei Stromschienen (210, 220) über einen jeweiligen des mindestens einen ersten und zweiten Kondensators (401, 402) mit dem Bezugspotential (N) verbunden sind und der mindestens eine dritte Kondensator (403) die mindestens zwei Stromschienen (210, 220) miteinander verbindet.

2. Filterbauelement nach Anspruch 1,
- wobei einer des ersten und zweiten Endabschnitts (212) der ersten Stromschiene (210) innerhalb der ersten Ebene (E1) in eine andere Richtung als der mittlere Abschnitt (213) der ersten Stromschiene (210) ausgerichtet ist,
- wobei einer des ersten und zweiten Endabschnitts (221) der mindestens einen zweiten Stromschiene (220) innerhalb der zweiten Ebene (E2) in eine andere Richtung als der mittlere Abschnitt (223) der zweiten Stromschiene (220) ausgerichtet ist.

3. Filterbauelement nach Anspruch 2,
- wobei der eine des ersten und zweiten Endabschnitts (212) der ersten Stromschiene (210) zu dem mittleren Abschnitt (213) der ersten Stromschiene in einem Winkel zwischen 80° und 100° angeordnet ist,
- wobei der eine des ersten und zweiten Endabschnitts (221) der zweiten Stromschiene (220) zu dem mittleren Abschnitt (223) der zweiten Stromschiene in einem Winkel zwischen 80° und 100° angeordnet ist.

4. Filterbauelement nach einem der Ansprüche 2 oder 3,
- wobei ein anderer des ersten und zweiten Endabschnitts (211) der ersten Stromschiene (210) innerhalb der ersten Ebene (E1) in die gleiche Richtung wie der mittlere Abschnitt (213) der ersten Stromschiene (210) ausgerichtet ist,
- wobei ein anderer des ersten und zweiten Endabschnitts (222) der mindestens einen zweiten Stromschiene (220) innerhalb der zweiten Ebene (E2) in die gleiche Richtung wie der mittlere Abschnitt (223) der mindestens einen zweiten Stromschiene (220) ausgerichtet ist.

5. Filterbauelement nach einem der Ansprüche 1 bis 4,
wobei die mindestens zwei Stromschienen (210, 220) jeweils L-förmig ausgebildet sind.

6. Filterbauelement nach einem der Ansprüche 1 bis 5,
wobei die mindestens zwei Stromschienen (210, 220) jeweils als ein Flachleiter ausgebildet sind.

7. Filterbauelement nach einem der Ansprüche 1 bis 6,
- wobei der jeweilige erste Anschluss (214, 224) der ersten und zweiten Stromschiene (210, 220) als eine Vertiefung in dem jeweiligen ersten Endabschnitt (211, 221) der ersten und zweiten Stromschiene ausgebildet ist,
- wobei der jeweilige zweite Anschluss (215, 225) der ersten und zweiten Stromschiene (210, 220) als eine Vertiefung in dem jeweiligen zweiten Endabschnitt (212, 222) der ersten und zweiten Stromschiene ausgebildet ist.

8. Filterbauelement nach einem der Ansprüche 1 bis 7,
- wobei der erste Anschluss (214) der ersten Stromschiene (210) als eine erste Fixierungseinrichtung zum Fixieren des ersten Endabschnitts (211) der ersten Stromschiene (210) an einem ersten elektrischen Leiter (10) zum Bereitstellen des ersten Potentials ausgebildet ist,
- wobei der zweite Anschluss (215) der ersten Stromschiene (210) als eine zweite Fixierungseinrichtung zum Fixieren des zweiten Endabschnitts (212) der ersten Stromschiene (210) an einem zweiten elektrischen Leiter (20) zum Ankoppeln des zweiten Endabschnitts (212) der ersten Stromschiene (210) an die erste elektrische Last (L1) oder das Bezugspotential (N) ausgebildet ist,
- wobei der erste Anschluss (224) der mindestens einen zweiten Stromschiene (220) als eine dritte Fixierungseinrichtung zum Fixieren des ersten Endabschnitts (221) der zweiten Stromschiene (220) an einen dritten elektrischen Leiter (30) zum Bereitstellen des zweiten Potentials ausgebildet ist,
- wobei der zweite Anschluss (225) der mindestens einen zweiten Stromschiene (220) als eine vierte Fixierungseinrichtung zum Fixieren des zweiten Endabschnitts (222) der mindestens zweiten Stromschiene (220) an einem vierten elektrischen Leiter (40) zum Ankoppeln des zweiten Endabschnitts (222) der mindestens einen zweiten Stromschiene (220) an die zweite elektrische Last (L2) oder das Bezugspotential (N) ausgebildet ist.

9. Filterbauelement nach Anspruch 8,
wobei mindestens einer des jeweiligen ersten und zweiten Anschlusses (214, 215, 224, 225) der mindestens zwei Stromschienen (210, 220) als ein Schraubengewinde ausgebildet ist.

10. Filterbauelement nach einem der Ansprüche 1 bis 9,
wobei die mindestens zwei Stromschienen (210, 220) derart ausgebildet sind, dass mindestens einer des jeweiligen ersten und zweiten Endabschnitts (211, 222) und der jeweilige mittlere Abschnitt (213, 223) der mindestens zwei Stromschienen (210, 220) in den mindestens einen magnetischen Kern (300) einschiebbar sind.

11. Filterbauelement nach einem der Ansprüche 1 bis 10,
wobei mindestens eine der ersten und der mindestens einen zweiten Stromschiene (210, 220) mehrere elektrische Leiter, die in dem Gehäusekörper (100) in einer Stapelanordnung angeordnet sind und von dem mindestens einen magnetischen Kern (300) umgeben sind, aufweist.

## Claims

1. Filter component comprising:
- a housing body (100),
- at least two busbars (210, 220), which each have a first end section (211, 221) and a second end section (212, 222), between which in each case a center section (213, 223) is arranged,
- at least one magnetic core (300), wherein the at least one magnetic core (300) is arranged in the housing body (100) and surrounds the respective center section (213, 223) of the at least two busbars (210, 220),
- at least one first capacitor (401), one second capacitor (402) and one third capacitor (403),
- wherein a first one of the busbars (210) has a first connection (214) for connecting a first potential and a second connection for connecting a first load (L1),
- wherein at least a second one of the busbars (220) has a first connection (224) for connecting a second potential, which is different from the first potential, and a second connection (225) for connecting a second load (L2), which is different from the first load, or for connecting a reference potential (N),
- wherein the respective first connection (214, 224) is arranged in the respective first end section (211) and the respective second connection (215, 225) is arranged in the respective second end section (212, 222) of the at least two busbars,
- wherein the respective first end section (211, 221) of the at least two busbars (210, 220) projects out of the housing body on a first side (S100a) of the housing body (100) and the respective second end section (212, 222) of the at least two busbars (210, 220) projects out of the housing body on a second side (S100b) of the housing body (100), which is different from the first side, and wherein the respective center section (213, 223) of the at least two busbars is arranged in the housing body (100),
- wherein the first end section (211), the second end section (212) and the center section (213) of the first busbar (210) are arranged in a first plane (E1),
- wherein the first end section (221), the second end section (222) and the center section (223) of the at least one second busbar (220) are arranged in a second plane (E2), which is different from the first plane,
- wherein the respective first end section (211, 221) of the at least two busbars (210, 220) is formed such that the first connection (214) of the first busbar (210) and the first connection (224) of the least one second busbar (220) are not oriented so as to align with one another,
- wherein the respective second end section (212, 222) of the at least two busbars (210, 220) is formed such that the second connection (215) of the first busbar (210) and the second connection (225) of the at least one second busbar (220) are not oriented so as to align with one another,
- wherein the at least two busbars (210, 220) are connected via a respective one of the at least one first and second capacitor (401, 402) to the reference potential (N) and the at least one third capacitor (403) connects the at least two busbars (210, 220) to one another.

2. Filter component according to Claim 1,
- wherein one of the first and second end sections (212) of the first busbar (210) in the first plane (E1) is oriented in a different direction from the center section (213) of the first busbar (210),
- wherein one of the first and second end sections (221) of the at least one second busbar (220) in the second plane (E2) is oriented in a different direction from the center section (223) of the second busbar (220).

3. Filter component according to Claim 2,
- wherein the one of the first and second end sections (212) of the first busbar (210) is arranged at an angle of between 80° and 100° with respect to the center section (213) of the first busbar,
- wherein the one of the first and second end sections (221) of the second busbar (220) is arranged at an angle of between 80° and 100° with respect to the center section (223) of the second busbar.

4. Filter component according to either of Claims 2 and 3,
- wherein another one of the first and second end sections (211) of the first busbar (210) in the first plane (E1) is oriented in the same direction as the center section (213) of the first busbar (210),
- wherein another one of the first and second end sections (222) of the at least one second busbar (220) in the second plane (E2) is oriented in the same direction as the center section (223) of the at least one second busbar (220) .

5. Filter component according to any of Claims 1 to 4, wherein the at least two busbars (210, 220) are each designed to be L-shaped.

6. Filter component according to any of Claims 1 to 5, wherein the at least two busbars (210, 220) are each designed as a flat conductor.

7. Filter component according to any of Claims 1 to 6,
- wherein the respective first connection (214, 224) of the first and second busbar (210, 220) is designed as a depression in the respective first end section (211, 221) of the first and second busbar,
- wherein the respective second connection (215, 225) of the first and second busbar (210, 220) is designed as a depression in the respective second end section (212, 222) of the first and second busbar.

8. Filter component according to any of Claims 1 to 7,
- wherein the first connection (214) of the first busbar (210) is designed as a first fastening device for fastening the first end section (211) of the first busbar (210) to a first electrical conductor (10) for providing the first potential,
- wherein the second connection (215) of the first busbar (210) is designed as a second fastening device for fastening the second end section (212) of the first busbar (210) to a second electrical conductor (20) for coupling the second end section (212) of the first busbar (210) to the first electrical load (L1) or to the reference potential (N),
- wherein the first connection (224) of the at least one second busbar (220) is designed as a third fastening device for fastening the first end section (221) of the second busbar (220) to a third electrical conductor (30) for providing the second potential,
- wherein the second connection (225) of the at least one second busbar (220) is designed as a fourth fastening device for fastening the second end section (222) of the at least one second busbar (220) to a fourth electrical conductor (40) for coupling the second end section (222) of the at least one second busbar (220) to the second electrical load (L2) or to the reference potential (N).

9. Filter component according to Claim 8,
wherein at least one of the respective first and second connections (214, 215, 224, 225) of the at least two busbars (210, 220) is designed as a screw thread.

10. Filter component according to any of Claims 1 to 9,
wherein the at least two busbars (210, 220) are designed such that at least one of the respective first and second end sections (211, 212) and the respective center section (213, 223) of the at least two busbars (210, 220) are insertable into the at least one magnetic core (300).

11. Filter component according to any of Claims 1 to 10,
wherein at least one of the first and the at least one second busbars (210, 220) has a plurality of electrical conductors which are arranged in the housing body (100) in a stack arrangement and are surrounded by the at least one magnetic core (300).

## Revendications

1. Composant de filtre, comprenant :
- un corps de boîtier (100),
- au moins deux barres omnibus (210, 220) dont chacune comporte une première partie d'extrémité (211, 221) et une deuxième partie d'extrémité (212, 222) entre lesquelles est respectivement disposée une partie intermédiaire (213, 223),
- au moins un noyau magnétique (300), dans lequel ledit au moins un noyau magnétique (300) est disposé dans le corps de boîtier (100) et entoure la partie centrale (213, 223) respective desdites au moins deux barres omnibus (210, 220),
- au moins un premier condensateur (401), un deuxième condensateur (402) et un troisième condensateur (403),
- dans lequel une première des barres omnibus (210) comporte une première borne (214) permettant de raccorder un premier potentiel et une deuxième borne permettant de raccorder une première charge (L1),
- dans lequel au moins une deuxième des barres omnibus (220) comporte une première borne (224) permettant de raccorder un deuxième potentiel différent du premier potentiel et une deuxième borne (225) permettant de raccorder une deuxième charge (L2) différente de la première charge ou permettant de raccorder un potentiel de référence (N),
- dans lequel la première borne (214, 224) respective est disposée dans la première partie d'extrémité (211) respective et la deuxième borne (215, 225) respective est disposée dans la deuxième partie d'extrémité (212, 222) respective desdites au moins deux barres omnibus,
- dans lequel la première partie d'extrémité (211, 221) respective desdites au moins deux barres omnibus (210, 220) sort du corps de boîtier sur un premier côté (S100a) du corps de boîtier (100) et la deuxième partie d'extrémité (212, 222) respective desdites au moins deux barres omnibus (210, 220) sort du corps de boîtier sur un deuxième côté (S100b) différent du premier côté (100) et dans lequel la partie centrale (213, 223) respective desdites au moins deux barres omnibus est disposée dans le corps de boîtier (100),
- dans lequel la première partie d'extrémité (211), la deuxième partie d'extrémité (212) et la partie centrale (213) de la première barre omnibus (210) sont disposées dans un premier plan (E1) ,
- dans lequel la première partie d'extrémité (221), la deuxième partie d'extrémité (222) et la partie centrale (223) de ladite au moins une deuxième barre omnibus (220) sont disposées dans un deuxième plan (E2) différent du premier plan,
- dans lequel la première partie d'extrémité (211, 221) respective desdites au moins deux barres omnibus (210, 220) est conformée de manière à ce que la première borne (214) de la première barre omnibus (210) et la première borne (224) de ladite au moins une deuxième barre omnibus (220) ne soient pas alignées l'une sur l'autre,
- dans lequel la deuxième partie d'extrémité (212, 222) respective desdites au moins deux barres omnibus (210, 220) est conformée de manière à ce que la deuxième borne (215) de la première barre omnibus (210) et la deuxième borne (225) de ladite au moins une deuxième barre omnibus (220) ne soient pas alignées l'une sur l'autre,
- dans lequel lesdites au moins deux barres omnibus (210, 220) sont reliées au potentiel de référence (N) par l'intermédiaire de l'un respectif desdits au moins un premier et deuxième condensateurs (401, 402) et ledit au moins un troisième condensateur (403) relie l'une à l'autre lesdites au moins deux barres omnibus (210, 220).

2. Composant de filtre selon la revendication 1,
- dans lequel l'une des première et deuxième parties d'extrémité (212) de la première barre omnibus (210) est orientée dans le premier plan (E1) dans une direction différente de la partie centrale (213) de la première barre omnibus (210),
- dans lequel l'une des première et deuxième parties d'extrémité (221) de ladite au moins une deuxième barre omnibus (220) est orientée dans ledit deuxième plan (E2) dans une direction différente de la partie centrale (223) de la deuxième barre omnibus (220).

3. Composant de filtre selon la revendication 2,
- dans lequel l'une des première et deuxième parties d'extrémité (212) de la première barre omnibus (210) est disposée selon un angle compris entre 80° et 100° par rapport à la partie centrale (213) de la première barre omnibus,
- dans lequel l'une des première et deuxième parties d'extrémité (221) de la deuxième barre omnibus (220) est disposée selon un angle compris entre 80° et 100° par rapport à la partie centrale (223) de la deuxième barre omnibus.

4. Composant de filtre selon l'une des revendications 2 ou 3,
- dans lequel une autre des première et deuxième parties d'extrémité (211) de la première barre omnibus (210) est alignée dans le premier plan (E1) dans la même direction que la partie centrale (213) de la première barre omnibus (210),
- dans lequel une autre des première et deuxième parties d'extrémité (222) de ladite au moins une deuxième barre omnibus (220) est alignée dans le deuxième plan (E2) dans la même direction que la partie centrale (223) de ladite au moins une deuxième barre omnibus (220).

5. Composant de filtre selon l'une des revendications 1 à 4, dans lequel lesdites au moins deux barres omnibus (210, 220) sont chacune en forme de L.

6. Composant de filtre selon l'une des revendications 1 à 5, dans lequel lesdites au moins deux barres omnibus (210, 220) sont respectivement réalisées sous la forme d'un conducteur plat.

7. Composant de filtre selon l'une des revendications 1 à 6,
- dans lequel les premières bornes (214, 224) respectives des première et deuxième barres omnibus (210, 220) sont réalisées sous la forme d'un évidement ménagé dans les premières parties d'extrémité (211, 221) respectives des première et deuxième barres omnibus,
- dans lequel la deuxième borne (215, 225) respective des première et deuxième barres omnibus (210, 220) est réalisée sous la forme d'un évidement ménagé dans la deuxième partie d'extrémité (212, 222) respective des première et deuxième barres omnibus.

8. Composant de filtre selon l'une des revendications 1 à 7,
- dans lequel la première borne (214) de la première barre omnibus (210) est réalisée sous la forme d'un premier moyen de fixation permettant de fixer la première partie d'extrémité (211) de la première barre omnibus (210) à un premier conducteur électrique (10) afin de fournir le premier potentiel,
- dans lequel la deuxième borne (215) de la première barre omnibus (210) est réalisée sous la forme d'un deuxième moyen de fixation permettant de fixer la deuxième partie d'extrémité (212) de la première barre omnibus (210) à un deuxième conducteur électrique (20) afin de coupler la deuxième partie d'extrémité (212) de la première barre omnibus (210) à la première charge électrique (L1) ou au potentiel de référence (N),
- dans lequel la première borne (224) de ladite au moins une deuxième barre omnibus (220) est réalisée sous la forme d'un troisième moyen de fixation permettant de fixer la première partie d'extrémité (221) de la deuxième barre omnibus (220) à un troisième conducteur électrique (30) afin de fournir le deuxième potentiel,
- dans lequel la deuxième borne (225) de ladite au moins une deuxième barre omnibus (220) est réalisée sous la forme d'un quatrième moyen de fixation permettant de fixer la deuxième partie d'extrémité (222) de ladite au moins une deuxième barre omnibus (220) à un quatrième conducteur électrique (40) afin de coupler la deuxième partie d'extrémité (222) de ladite au moins une deuxième barre omnibus (220) à la deuxième charge électrique (L2) ou au potentiel de référence (N).

9. Composant de filtre selon l'une des revendications 1 à 9, dans lequel au moins l'une des première et deuxième bornes (214, 215, 224, 225) respectives desdites au moins deux barres omnibus (210, 220) est réalisée sous la forme d'un filetage.

10. Composant de filtre selon l'une des revendications 1 à 9, dans lequel lesdites au moins deux barres omnibus (210, 220) sont réalisées de manière à ce qu'au moins l'une des première et deuxième parties d'extrémité (211, 222) respectives et de la partie centrale (213, 223) respective desdites au moins deux barres omnibus (210, 220) puisse être insérée dans ledit au moins un noyau magnétique (300).

11. Composant de filtre selon l'une des revendications 1 à 10, dans lequel au moins l'une des première et desdites au moins une deuxième barres omnibus (210, 220) comprend une pluralité de conducteurs électriques qui sont disposés dans le corps de boîtier (100) selon un agencement d'empilement et sont entourés par ledit au moins un noyau magnétique (300).
